# EUROPEAN PATENT APPLICATION

(11) **EP 4 033 524 A1**
(43) Date of publication of application: **27.07.2022**
(21) Application number: 20866045.6
(22) Date of filing: 15.09.2020
(51) Int. Cl.: H01L 23/13, H01L 23/12, H01L 25/07, H01L 25/18, H05K 3/34

(54) **CIRCUIT BOARD AND MODULE COMPRISING SAME**

(30) Priority: 20.09.2019 JP 2019171912
(71) Applicant: Denka Company Limited, Tokyo 103-8338 (JP)
(72) Inventor: YUASA, Akimasa, Tokyo 103-8338 (JP); KOBASHI, Seiji, Tokyo 103-8338 (JP); NISHIMURA, Koji, Tokyo 103-8338 (JP)
(74) Representative: Gulde & Partner
(86) International application number: PCT/JP2020/034891
(87) International publication number: WO 2021/054316

(57) **Abstract**

A circuit substrate includes: a ceramic substrate 10, one or more circuit boards 20 bonded to the ceramic substrate 10, and solder resist 30 on a surface of at least one circuit board 20. When viewed in a cross section perpendicular to a bonding surface 20a between the circuit board 20 having the solder resist 30 thereon and the ceramic substrate 10, a distance L₁ between a circuit edge 25 of the circuit board 20 and an inner edge 30A of the solder resist 30 along the bonding surface 20a is 1.0 mm or more.

## Description

### Technical Field

The present disclosure relates to a circuit substrate and a module including the same.

### Background Art

As performance of industrial equipment such as robots and motors has increased, the amount of heat generated from semiconductor elements mounted on power modules has also increased. In order to efficiently dissipate the heat, a circuit substrate including a ceramic substrate having good thermal conductivity is used. In such a circuit substrate, thermal stress is generated due to a heat cycle at the time of heating and cooling processes when bonding the ceramic substrate and a metal plate and at the time of using the circuit substrate. Accordingly, cracks may be generated in the ceramic substrate or the metal plate may be peeled off.

Therefore, in order to alleviate the thermal stress generated in the ceramic circuit substrate, Patent Document 1 proposes to set an angle of a circuit edge portion of a metal circuit provided on one surface of a ceramic substrate within a predetermined range. In Patent Document 2, it is proposed that the shape of an edge portion of a copper plate be made specific in order to improve durability against heat cycling.

### Citation List

### Patent Literature

[Patent Document 1] Japanese Unexamined Patent Publication No. 2013-175525
[Patent Document 2] PCT International Publication No. WO2013/094213

### Summary of Invention

### Technical Problem

The circuit substrate is required to be sufficiently excellent in reliability depending on the use. For example, in a field of a driving unit of an electric train or a power module of an electric vehicle, it is required to maintain excellent reliability even under severe conditions of a heat cycle. On the other hand, if an electrode is connected to a circuit board using solder when the circuit substrate is modularized, for example, thermal stress (tensile stress) is generated in a ceramic substrate due to the solder applied to the surface of the circuit board. This thermal stress is concentrated in the vicinity of a circuit edge of the circuit board in the ceramic substrate, which causes a decrease in durability in the heat cycle.

Therefore, the present disclosure provides a circuit substrate and a module having excellent heat cycle resistance.

### Solution to Problem

A circuit substrate according to an aspect of the present disclosure includes: a ceramic substrate, one or more circuit boards bonded to the ceramic substrate, and solder resist on a surface of at least one of the circuit boards, in which, when viewed in a cross section perpendicular to a bonding surface between the circuit board having the solder resist thereon and the ceramic substrate, a distance L₁ between a circuit edge of the circuit board and an inner edge of the solder resist along the bonding surface is 1.0 mm or more.

The circuit substrate includes the solder resist on the surface of at least one circuit board. Therefore, the solder can be prevented from flowing out to the vicinity of the circuit edge of the circuit board. Since the distance L₁ between the circuit edge of the circuit board and the inner edge of the solder resist is 1.0 mm or more, the solder is prevented from flowing out to the vicinity of the circuit edge. Accordingly, thermal stress generated in the vicinity of the circuit edge of the circuit board in the ceramic substrate is reduced, and heat cycle resistance can be improved.

When viewed in the cross-sectional view, the circuit board may have, at a side portion thereof, a gradient portion expanding toward the bonding surface. Accordingly, the thermal stress generated in the vicinity of the circuit edge of the circuit board in the ceramic substrate is diffused, and heat cycle resistance can be further improved.

When viewed in the cross-section, whole of a side portion of the circuit board may be formed to expand toward the bonding surface. Accordingly, the thermal stress generated in the vicinity of the circuit edge of the circuit board in the ceramic substrate is diffused, and heat cycle resistance can be further improved.

When viewed in the cross-sectional view, the circuit board may have, at a side portion thereof, a gradient portion expanding toward the bonding surface and a reverse gradient portion expanding away from the bonding surface in this order from the bonding surface side.

The surface of the circuit board may be formed of a plating film containing nickel and phosphorus. The circuit board whose surface is formed of the plating film has good wettability of the solder and the solder easily flows on the surface. Since the above-described circuit substrate includes the solder resist and the distance L₁ is equal to or greater than a predetermined value, it is possible to prevent the solder from flowing out to the vicinity of the circuit edge even when the surface of the circuit board is formed of the plating film. Therefore, heat cycle resistance can be improved.

The circuit substrate may include a metal portion and a brazing layer bonding the metal portion and the ceramic substrate. The brazing layer may include Ag, Cu, Sn, and Ti, and may include more than 4 parts by mass or more of Sn with respect to 100 parts by mass of a total of Ag and Cu. The bonding portion having the brazing layer can sufficiently firmly bond the ceramic substrate and the circuit board.

A module according to an aspect of the present disclosure includes any one of the above-described circuit substrates, an electrode electrically connected to the circuit board by a solder, and a heat dissipation portion on a side of the circuit substrate opposite to the circuit board side. Since the circuit substrate includes the solder resist on the surface of the circuit board and the distance L₁ is equal to or greater than the predetermined value, it is possible to prevent the solder from flowing out to the vicinity of the circuit edge of the circuit board. Therefore, the thermal stress generated in the vicinity of the circuit edge of the circuit board in the ceramic substrate is reduced, and heat cycle resistance of the module can be improved.

### Advantageous Effects of Invention

According to the present disclosure, it is possible to provide a circuit substrate and a module having excellent heat cycle resistance.

### Brief Description of Drawings

FIG. 1 is a plan view of a circuit substrate according to an embodiment.
FIG. 2 is a cross-sectional view taken along line II-II of FIG. 1.
FIG. 3 is an enlarged cross-sectional view illustrating the vicinity of a circuit edge of a circuit board in a circuit substrate according to an embodiment.
FIG. 4 is an enlarged cross-sectional view illustrating a cross section near a circuit edge of a circuit board in a circuit substrate according to another embodiment.
FIG. 5 is an enlarged cross-sectional view illustrating a cross section near a circuit edge of a circuit board in a circuit substrate according to still another embodiment.
FIG. 6 is a cross-sectional view schematically illustrating a module according to an embodiment.

### Description of Embodiments

Hereinafter, an embodiment of the present disclosure will be described with reference to the drawings in some cases. However, the following embodiments are merely examples for explaining the present disclosure, and the present disclosure is not limited to the following contents. In the following description, the same element or element having the same function is denoted by the same reference numeral, and redundant description will be omitted in some cases. Further, positional relationship such as up, down, left, and right is based on the positional relationship illustrated in the drawings unless otherwise specified. Further, the dimensional ratio of each element is not limited to the illustrated ratio.

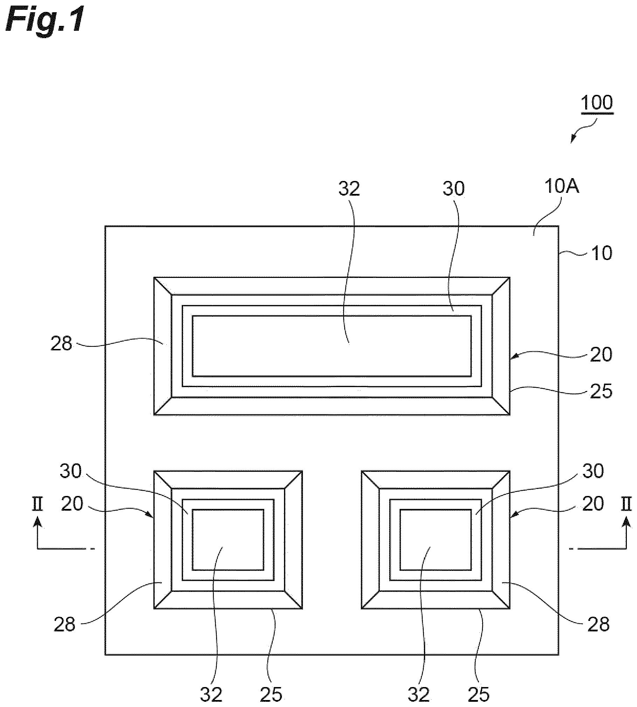

FIG. 1 is a plan view of the circuit substrate of the present embodiment. The circuit substrate 100 includes a ceramic substrate 10, three circuit boards 20 bonded to a surface 10A of the ceramic substrate 10, and solder resist 30 on surfaces of the circuit boards 20. The solder resist 30 is provided along the upper edge of the surface of the circuit board 20 to define solder application region 32 on the surface of the circuit board 20. In the present disclosure, the outer edge of the circuit board 20 at the bonding surface between the circuit board 20 and the ceramic substrate 10 is referred to as a circuit edge 25.

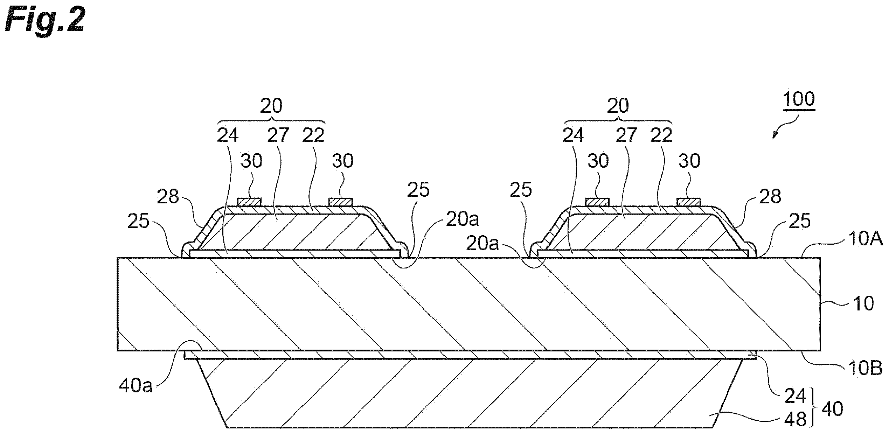

FIG. 2 is a cross-sectional view taken along line II-II of FIG. 1. The circuit board 20 is bonded to the ceramic substrate 10 at a bonding surface 20a. FIG. 2 illustrates a cross section of the circuit substrate 100 taken along a plane perpendicular to the bonding surface 20a. The circuit board 20 is bonded to the front surface 10A of the ceramic substrate 10, and a heat dissipation plate 40 is bonded to the back surface 10B. The circuit board 20 and the heat dissipation plate 40 may be made of the same material or different materials. From the viewpoint of improving conductivity and heat dissipation, for example, the circuit board 20 and the heat dissipation plate 40 may contain Cu as a main component. While the circuit board 20 has a function of transmitting an electric signal, the heat dissipation plate 40 may have a function of transmitting heat. However, the heat dissipation plate 40 may have a function of transmitting an electric signal.

The circuit board 20 and the heat dissipation plate 40 each have a brazing layer 24. The circuit board 20 and the heat dissipation plate 40 are bonded to the front surface 10A and the back surface 10B of the ceramic substrate 10 by the brazing layer 24. The circuit board 20 and the heat dissipation plate 40 may have the same or different material and thickness of the brazing layer 24.

The circuit board 20 is formed such that whole of a side portion 28 expands toward the bonding surface 20a of the ceramic substrate 10 and the circuit board 20. Similarly, a side portion 48 of the heat dissipation plate 40 is also formed to expand toward the bonding surface 40a of the ceramic substrate 10 and the heat dissipation plate 40. The thickness of the ceramic substrate 10 may be, for example, 0.5 to 2 mm, or may be 0.9 to 1.1 mm. The thickness of the circuit board 20 may be, for example, 0.1 to 1 mm, or may be 0.2 to 0.5 mm. The thickness of the heat dissipation plate 40 may be, for example, 0.1 to 1 mm, or may be 0.2 to 0.4 mm.

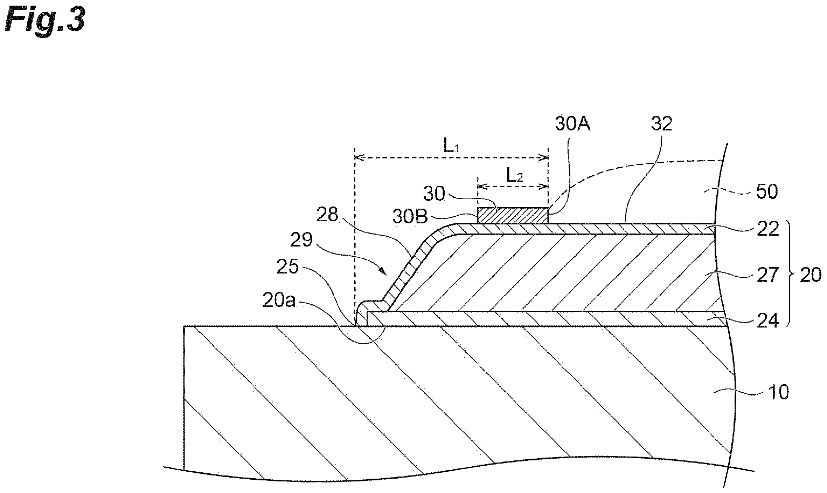

FIG. 3 is an enlarged cross-sectional view illustrating the vicinity of the circuit edge 25 of the circuit board 20 in the circuit substrate 100. Similarly to FIG. 2, FIG. 3 illustrates a cross section taken along a plane perpendicular to the bonding surface 20a. The circuit board 20 has, on the side portion 28, a gradient portion 29 which expands toward the bonding surface 20a of the ceramic substrate 10 and the circuit board 20. The circuit board 20 is formed such that whole of the side portion 28 expands toward the bonding surface 20a.

A distance L₁ between the circuit edge 25 and an inner edge 30A of the resist solder 30 along the bonding surface 20a is 1.0 mm or more. Accordingly, thermal stress generated in the vicinity of the circuit edge 25 of the circuit board 20 in the ceramic substrate 10 is reduced, and heat cycle resistance can be improved. From the same viewpoint, the distance L₁ may be 1.5 mm or more. From the viewpoint of ensuring a sufficient size of the solder application region 32, the distance L₁ may be 5 mm or less, or may be 4 mm or less.

From the viewpoint of sufficiently preventing solder from flowing out of the solder application region 32 while ensuring the sufficient size of the solder application region 32, the width of the solder resist 30, that is, a distance L₂ between the inner edge 30A and the outer edge 30B of the solder resist 30 may be 0.5 mm to 3 mm, and may be 1.0 mm to 2.0 mm. The difference between the distance L₁ and the distance L₂ (L₁ - L₂) may be 0.3 to 1.5 mm. This makes it possible to sufficiently prevent the solder from flowing out of the solder application region 32 while sufficiently maintaining the effect of reducing the thermal stress.

The solder resist 30 can be formed using an ordinary material and contains, for example, a resin component such as an epoxy resin and inorganic particles. The circuit board 20 includes a metal portion 27 therein, a plating film 22 covering the metal portion 27, and the brazing layer 24 on the ceramic substrate 10 side. The metal portion 27 may be made of, for example, copper, aluminum, or an alloy thereof from the viewpoint of improving conductivity and thermal conductivity.

The plating film 22 may be an electroless Ni plating film from the viewpoint of improving solder wettability. The electroless Ni plating film may be a nickel-phosphorus plating film containing 1 to 12% by mass of nickel. By providing such an electroless Ni plating film, the circuit substrate 100 can have excellent solder wettability while having excellent heat cycle resistance.

The ceramic substrate 10 may contain aluminum nitride. The brazing layer 24 having a function of bonding the ceramic substrate 10 and the circuit board 20 may be formed by heating a brazing material. The brazing layer 24 contains, for example, Ag, Cu, Sn, and Ti. Since Ti reacts with aluminum nitride, the bonding strength between the ceramic substrate 10 containing aluminum nitride and the circuit board 20 can be sufficiently increased by containing Ti. From the viewpoint of promoting the reaction, Ti may be contained as a hydride (TiH₂). The content of TiH₂ with respect to 100 parts by mass of the total of Ag and Cu may be, for example, 1 to 8 parts by mass. From the viewpoint of relaxing thermal stress generated between the ceramic substrate 10 and the circuit board 20, the content of Zr with respect to 100 parts by mass of the total of Ag and Cu may be less than 2 parts by mass or less than 1 part by mass.

The brazing layer 24 may bond the ceramic substrate 10 and the circuit board 20 at a low temperature by containing Sn. Hence, the content of Sn with respect to 100 parts by mass of the total of Ag and Cu may be 4 parts by mass or more, or may be 8 parts by mass or more. When the content of Sn is too large, a compound of Ti and Si is generated, and a bonding failure portion may be partially generated. Therefore, the content of Sn with respect to 100 parts by mass of the total of Ag and Cu may be 30 parts by mass or less, or may be 20 parts by mass or less. The thickness of the brazing layer 24 may be 3 to 20 µm, and may be 5 to 15 µm. The thickness of the plating film 22 may be 1 to 8 µm, and may be 2 to 6 µm.

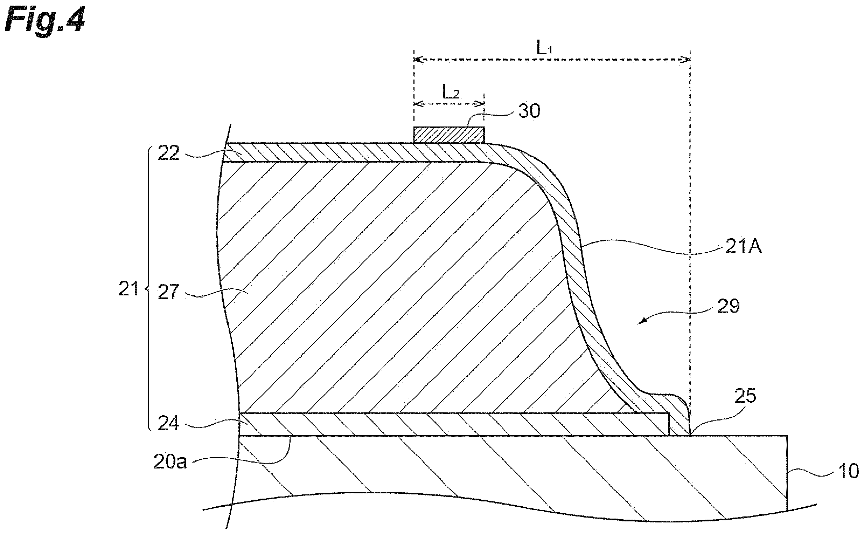

FIG. 4 is an enlarged cross-sectional view illustrating a cross section near a circuit edge of a circuit board in a circuit substrate according to another embodiment. Similarly to FIG. 3, FIG. 4 illustrates a cross section perpendicular to the bonding surface 20a. Similarly to the circuit board 20 of FIG. 3, the circuit board 21 of FIG. 4 has a gradient portion 29 at a side portion 21A, which expands toward the bonding surface 20a. The circuit board 21 is also formed such that whole of the side portion 28 expands toward the bonding surface 20a.

In the circuit substrate according to the present embodiment, the circuit board 21 having such a shape is bonded to the ceramic substrate 10 instead of the circuit board 20. In such a circuit substrate, the thermal stress generated in the ceramic substrate 10 in the vicinity of the circuit edge 25 of the circuit board 21 is diffused, and heat cycle resistance of the circuit substrate can be further improved. The contour of the side portion 21A of the circuit board 21 may have a curved shape having two inflection points as illustrated in FIG. 4, a curved shape having three or more inflection points, or a stepped shape. Similarly to the circuit board 20 of FIG. 3, the circuit board 21 includes a plating film 22, a metal portion 27, and a brazing layer 24.

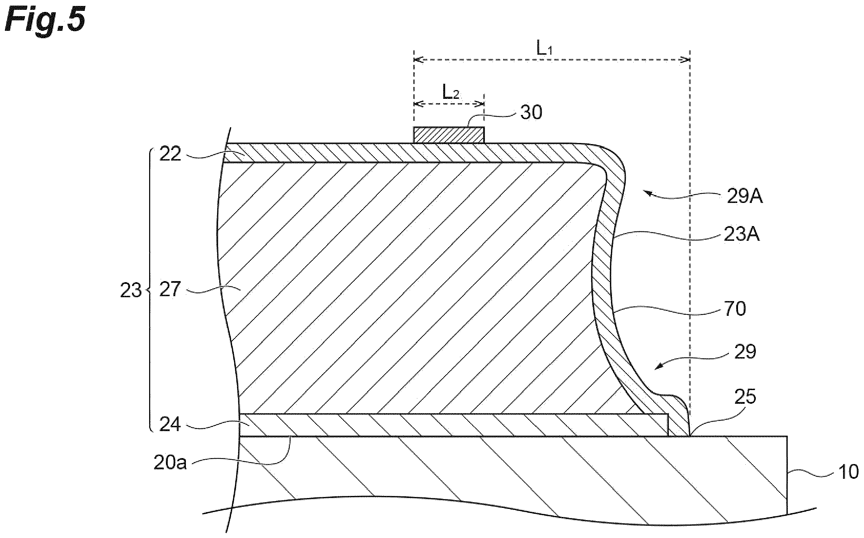

FIG. 5 is an enlarged cross-sectional view illustrating a cross section in the vicinity of a circuit edge of a circuit board in a circuit substrate according to still another embodiment. Similarly to FIG. 3, FIG. 5 illustrates a cross section perpendicular to the bonding surface 20a. In a side portion 23A of a circuit board 23 of FIG. 5, a recess 70 is formed between an upper end and a lower end of the circuit board 23 so as to be recessed toward the inside of the circuit board 23 with respect to the upper end and the lower end. The circuit board 23 has, on the side portion 23A, a gradient portion 29 expanding toward the bonding surface 20a between the ceramic substrate 10 and the circuit board 23, and a reverse gradient portion 29A expanding away from the bonding surface 20a in this order from the bonding surface 20a side. The circuit board 20 and the circuit board 21 of FIGS. 3 and 4 do not have a reverse gradient portion.

In the circuit substrate according to the present embodiment, the circuit board 23 having such a shape is bonded to the ceramic substrate 10 instead of the circuit board 20. Even in such a circuit substrate, with the distance L₁ in the above-described range, the thermal stress generated in the ceramic substrate 10 in the vicinity of the circuit edge 25 of the circuit board 23 is reduced, and heat cycle resistance of the circuit substrate can be improved. Similarly to the circuit board 20 of FIG. 3, the circuit board 23 includes a plating film 22, a metal portion 27, and a brazing layer 24.

An example of a method for producing a circuit substrate of the present disclosure will be described. First, a green sheet is obtained by forming slurry containing an inorganic compound powder, a binder resin, a sintering aid, a plasticizer, a dispersant, a solvent, and the like.

Examples of the inorganic compound include aluminum nitride (AlN), silicon nitride (Si₃N₄), silicon carbide, and aluminum oxide. Examples of the sintering aid include rare earth metals, alkaline earth metals, metal oxides, fluorides, chlorides, nitrates, and sulfates. These may be used alone or in combination of two or more. By using the sintering aid, sintering of the inorganic compound powder can be promoted. Examples of the binder resin include methyl cellulose, ethyl cellulose, polyvinyl alcohol, polyvinyl butyral, and (meth)acrylic resins.

Examples of the plasticizer include phthalic acid-based plasticizers such as purified glycerin, glycerin trioleate, diethylene glycol, and di-n-butyl phthalate, and dibasic acid-based plasticizers such as di-2-ethylhexyl sebacate. Examples of dispersants include poly(meth)acrylates and (meth)acrylic acid-maleate copolymers. Examples of the solvent include organic solvents such as ethanol and toluene.

Examples of the method for forming the slurry include a doctor blade method and an extrusion forming method. Next, the green sheet obtained by forming is degreased and sintered. The degreasing may be performed by heating at 400 to 800 °C for 0.5 to 20 hours, for example. This makes it possible to reduce the residual amount of organic materials (carbon) while preventing oxidation and deterioration of the inorganic compound. The sintering is performed by heating to 1700 to 1900 °C in non-oxidizing gas atmosphere such as nitrogen, argon, ammonia, or hydrogen. Thus, the ceramic substrate 10 can be obtained. If necessary, the ceramic substrate 10 may be shaped by cutting the edge portions thereof by laser processing.

The above-described degreasing and sintering may be performed in a state where a plurality of green sheets are laminated. When the green sheets are degreased and sintered in laminated state, a release layer made of a release agent may be provided between the green sheets in order to smoothly separate the base material after firing. For example, boron nitride (BN) can be used as the release agent. The release layer may be formed, for example, by applying a slurry of boron nitride powder by a method such as spraying, brushing, roll coating, or screen printing. The number of green sheets to be laminated may be, for example, 5 to 100, or may be 10 to 70, from the viewpoint of sufficiently progressing degreasing while efficiently performing mass production of the ceramic substrate.

Thus, the ceramic substrate 10 as illustrated in FIGS. 1 and 2 is obtained. Subsequently, a step of obtaining a composite substrate using the ceramic substrate 10 and a pair of metals substrate is performed. In detail, first, a pair of metals substrate is attached to the front surface 10A and the back surface 10B of the ceramic substrate 10 by brazing material. The metallic substrate may have a flat plate shape similar to the ceramic substrate 10. The brazing material is applied to the front surface 10A and the back surface 10B of the ceramic substrate 10 by a roll coater process, a screen-printing process, a transfer process, or the like. The brazing material contains, for example, metals and metal compound components such as Ag, Cu, Sn, and TiH₂, an organic solvent, a binder, and the like. The viscosity of the brazing material may be, for example, 5 to 20 Pa·s. The content of the organic solvent in the brazing material may be, for example, 5 to 25% by mass, and the content of the binder may be, for example, 2 to 15% by mass.

After the metallic substrates are bonded to the front surface 10A and the back surface 10B of the ceramic substrate 10 to which the brazing material is applied, the ceramic substrate 10 and the metallic substrates are sufficiently bonded by heating in a heating oven to obtain the composite substrate. The heating temperature may be, for example, 700 to 900 °C. The atmosphere in the furnace may be an inert gas such as nitrogen, and the heating may be performed under a reduced pressure lower than atmospheric pressure or under vacuum. The heating furnace may be of a continuous type for continuously producing a plurality of bonded bodies, or may be of a batch type for producing one or a plurality of bonded bodies. The heating may be performed while pressing the bonded body in the stacking direction.

Next, a part of the metallic substrate in the composite substrate is removed to form a circuit board 20. This step may be performed by photolithography, for example. In particular, first, a photosensitive resist is printed on the surface of the composite substrate. Then, a resist pattern having a predetermined shape is formed using an exposure apparatus. The resist may be negative or positive. The uncured resist is removed by, for example, washing.

After the resist pattern is formed, a portion of the metallic substrate not covered with the resist pattern is removed by etching. Accordingly, the front surface 10A and the back surface 10B of the ceramic substrate 10 are partially exposed at the corresponding portion. Thereafter, the resist pattern is removed to obtain a circuit substrate 100. An example of the method of manufacturing the circuit substrate 100 has been described above, but the method is not limited thereto. The shape of the side portion 28 of the circuit board 20 can be adjusted by changing the etching condition or the number of times of etching.

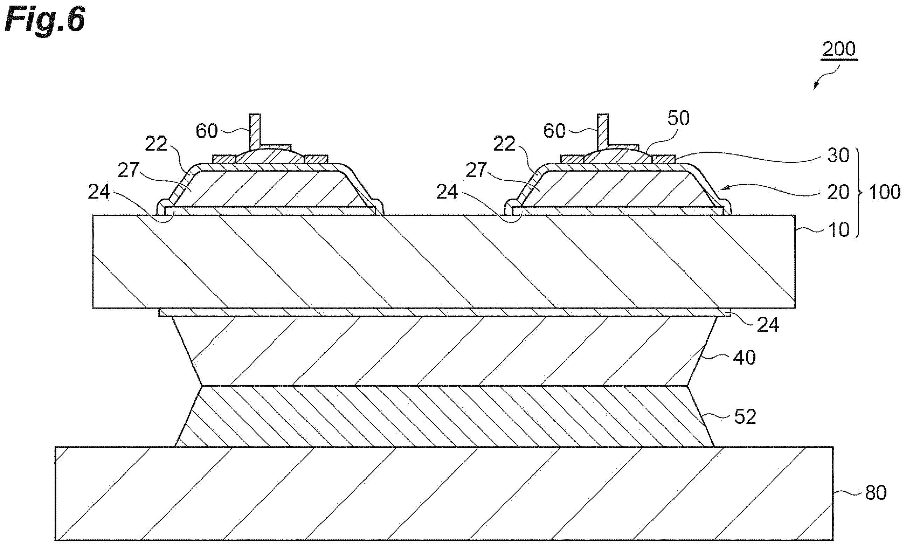

FIG. 6 is a cross-sectional view schematically illustrating a module according to an embodiment. The module 200 of FIG. 6 may be, for example, a power module that handles a large current because of its excellent heat cycle resistance. The module 200 includes a circuit substrate 100 and a heat dissipation portion 80 bonded to the heat dissipation plate 40 side of the circuit substrate 100 via a solder connection portion 52. The heat dissipation portion 80 has a higher thermal conductivity than the circuit board 20 and the heat dissipation plate 40. By providing such a heat dissipation portion 80, a semiconductor element or the like connected to the electrode 60 can be efficiently cooled. The heat dissipation portion may be composed of a composite material of a metal such as aluminum and a ceramic such as SiC. The solder connection portion 52 may be a Pb-free solder or a eutectic solder of Sn and Pb.

An L-shaped electrode 60 is electrically connected to the circuit board 20 of the circuit substrate 100 in the module 200 by the solder 50. The electrode 60 may be connected to a semiconductor element (not illustrated). That is, the module 200 may be a semiconductor module. The solder 50 may be a Pb-free solder or a eutectic solder of Sn and Pb. The solder 50 is provided in the solder application region 32. Since the distance L₁ of the circuit substrate 100 is equal to or greater than the predetermined value, the solder 50 can be prevented from being formed in the vicinity of the circuit edge 25 of the circuit board 20. Therefore, the thermal stress generated in the ceramic substrate 10 in the vicinity of the circuit edge 25 of the circuit board 20 is reduced, and heat cycle resistance of the module 200 can be improved.

The embodiments of the present disclosure have been described above, but the present disclosure is not limited to the above embodiments. For example, the circuit substrate in the module 200 may not be the circuit board 20, but may include the circuit board 21 of FIG. 4, the circuit board 23 of FIG. 5, or a circuit board having a shape different from these. The heat dissipation plate 40 provided on the back surface 10B of the ceramic substrate 10 may have the same shape as the circuit board 20, the circuit board 21, or the circuit board 23. Further, the distance L₁ in all the circuit boards in the circuit substrate does not need to be in the above-described range, and the distance L₁ in at least one circuit board may be in the above-described range.

### [EXAMPLES]

The contents of the present disclosure will be described in more detail with reference to examples and comparative examples, but the present disclosure is not limited to the following examples.

### [Production of Circuit Substrate]

(Example 1-1) A circuit substrate having a cross-sectional structure as illustrated in FIG. 2 was produced by the following procedure. A ceramic substrate made of aluminum nitride having a thickness of 1 mm, the copper plate A having a thickness of 0.3 mm, and the copper plate B having a thickness of 0.25 mm were prepared. The brazing material a was applied to predetermined portions of both surfaces of the ceramic substrate. The composition of the brazing material a was as shown in Table 1. The numbers in Table 1 indicate parts by mass of each component when the total of Ag and Cu is 100 parts by mass.

The copper plate A, the ceramic substrate, and the copper plate B were bonded in this order by the brazing material a, and heated at 800 °C for 1 hour in vacuum. Thus, the copper plate A and the copper plate B were bonded to the ceramic substrate to obtain a composite substrate. After a resist pattern having a predetermined shape was formed on the copper plate A using an exposure apparatus, etching was performed using a copper chloride aqueous solution and then a mixed solution of hydrogen peroxide and acidic ammonium fluoride to remove a portion not covered with the resist pattern. Thereafter, the resist pattern was removed with an alkali stripping solution.

Thereafter, a second etching was performed with a copper chloride aqueous solution to adjust the shape of a metal portion to be a component of a circuit board on the ceramic substrate. Thereafter, electroless plating was performed using a Ni-P plating solution (phosphorus concentration: 8 to 12% by mass) to form a circuit board having a plating film on the ceramic substrate. As illustrated in FIG. 4, the circuit board was formed such that whole of the side portion expanded toward the bonding surface.

Solder resist was applied to a predetermined position on the upper surface of the circuit board and dried to obtain a circuit substrate having a cross-sectional structure as illustrated in FIG. 3. The distances L₁ and L₂ in FIG. 3 were as shown in Table 2.

### (Example 1-2)

A circuit substrate was produced in the same manner as in Example 1-1 except that brazing material b in Table 1 was used instead of the brazing material a.

### (Example 1-3)

A circuit substrate was produced in the same manner as in Example 1-1 except that the second etching using the copper chloride aqueous solution was not performed. As illustrated in FIG. 5, in the side portion of the circuit board, a recess is formed between the upper end and the lower end of the circuit board 23 so as to be recessed toward the inside of the circuit board 23 with respect to the upper end and the lower end. That is, the circuit board had a gradient portion expanding toward the bonding surface and a reverse gradient portion expanding away from the bonding surface in this order from the bonding surface side in the side portion.

### (Example 2-1)

A circuit substrate was produced in the same manner as in Example 1-1 except that the position of the solder resist was adjusted so as to set the distances L₁ and L₂ as shown in Table 2.

### (Example 2-2)

A circuit substrate was produced in the same manner as in Example 1-2 except that the position of the solder resist was adjusted so as to set the distances L₁ and L₂ as shown in Table 2.

### (Example 2-3)

A circuit substrate was produced in the same manner as in Example 1-3 except that the position of the solder resist was adjusted so as to set the distances L₁ and L₂ as shown in Table 2.

### (Comparative Example 1-1)

A circuit substrate was produced in the same manner as in Example 1-1 except that the position of the solder resist was adjusted so as to set the distances L₁ and L₂ as shown in Table 2.

### (Comparative Example 1-2)

A circuit substrate was produced in the same manner as in Example 1-2 except that the position of the solder resist was adjusted so as to set the distances L₁ and L₂ as shown in Table 2.

### (Comparative Example 1-3)

A circuit substrate was produced in the same manner as in Example 1-3 except that the position of the solder resist was adjusted so as to set the distances L₁ and L₂ as shown in Table 2.

### (Comparative Example 2-1)

A circuit substrate was produced in the same manner as in Example 1-1 except that the distance L₁ and the distance L₂ were set as shown in Table 2. That is, the circuit substrate was produced in the same manner as in Example 1-1 except that the solder resist was not provided.

### (Comparative Example 2-2)

A circuit substrate was produced in the same manner as in Example 1-2 except that the distance L₁ and the distance L₂ were set as shown in Table 2. That is, the circuit substrate was produced in the same manner as in Example 1-2 except that the solder resist was not provided.

### (Comparative Example 2-3)

A circuit substrate was produced in the same manner as in Example 1-3 except that the distance L₁ and the distance L₂ were set as shown in Table 2. That is, the circuit substrate was produced in the same manner as in Example 1-3 except that the solder resist was not provided.

**Table 1**

| | Ag | Cu | Sn | TiH₂ | Zr |
|---|---|---|---|---|---|
| brazing material a | 90 | 10 | 3 | 3.5 | 2 |
| brazing material b | 90 | 10 | 12 | 3.5 | 0 |

### [Evaluation of heat cycle resistance]

An L-shaped copper electrode was prepared. The copper electrode was connected to the circuit board of the circuit substrate of each of Examples and Comparative Examples using a eutectic solder. At this time, the eutectic solder was prevented from protruding outside the solder application region of the circuit board. In Comparative Examples 2-1 to 2-3, the eutectic solder was prevented from protruding to the side portion of the circuit board.

Heat cycle resistance of each circuit substrate to which the copper electrode was connected by the solder was evaluated by the following procedure. A series of steps of cooling each circuit substrate at -40 °C for 30 minutes and then heating at 125 °C for 30 minutes was defined as one cycle, and the cycle was repeated 100 times. Thereafter, portions other than the ceramic substrate were removed by etching, and the vicinity of the circuit edge of the circuit board in the surface of the ceramic substrate was observed with an optical microscope (magnification: 20 times) to evaluate the presence or absence of cracks. For each of Examples and Comparative Examples, two circuit substrates were produced and evaluated. The number of circuit substrates in which cracks were generated is shown in the column of "Condition 1" in Table 2.

After repeating the above cycle 200 times, the presence or absence of cracks was evaluated in the same manner as described above. The number of circuit substrates in which cracks were generated is shown in the column of "Condition 2" in Table 2.

**Table 2**

| | Type of brazing material | Shape of side portion | Solder resist | | Number of cracks generated | |
|---|---|---|---|---|---|---|
| | | | Distance L₁ | Distance L₂ | Condition 1 | Condition 2 |
| | | | mm | mm | piece | piece |
| Example 1-1 | brazing material a | FIG. 4 | 1.0 | 0.5 | 0 | 0 |
| Example 1-2 | brazing material b | FIG. 4 | 1.0 | 0.5 | 0 | 0 |
| Example 1-3 | brazing material a | FIG. 5 | 1.0 | 0.5 | 0 | 0 |
| Example 2-1 | brazing material a | FIG. 4 | 1.5 | 0.5 | 0 | 0 |
| Example 2-2 | brazing material b | FIG. 4 | 1.5 | 0.5 | 0 | 0 |
| Example 2-3 | brazing material a | FIG. 5 | 1.5 | 0.5 | 0 | 0 |
| Comparative Example 1-1 | brazing material a | FIG. 4 | 0.5 | 0.5 | 0 | 1 |
| Comparative Example 1-2 | brazing material b | FIG. 4 | 0.5 | 0.5 | 0 | 0 |
| Comparative Example 1-3 | brazing material a | FIG. 5 | 0.5 | 0.5 | 1 | 2 |
| Comparative Example 2-1 | brazing material a | FIG. 4 | 0 | 0 | 2 | 2 |
| Comparative Example 2-2 | brazing material b | FIG. 4 | 0 | 0 | 2 | 2 |
| Comparative Example 2-3 | brazing material a | FIG. 5 | 0 | 0 | 2 | 2 |

Table 2 also shows the type of brazing material and the shape of the side portion of the circuit board. In each of Comparative Examples 2-1 to 2-3, cracks were generated in the evaluation of resistance. In Comparative Examples 1-1 to 1-3, the number of generated cracks varied depending on the type of the brazing material and the shape of the side portion. On the other hand, in each of Examples 1-1 to 1-3 and Examples 2-1 to 2-3, no crack was generated. That is, as shown in Table 2, it was confirmed that heat cycle resistance was improved by setting the distance L₁ along the bonding surface between the circuit edge of the circuit board and the inner edge of the solder resist to be 1.0 mm or more.

### Industrial Applicability

According to the present disclosure, a circuit substrate and a module having excellent heat cycle resistance are provided.

### Reference Signs List

10: ceramic substrate, 10A: front surface, 10B: back surface, 20, 21, 23: circuit board, 40: heat dissipation plate, 20a, 40a: bonding surface, 21A, 23A, 28: side portion, 22: plating film, 24: brazing layer, 25: circuit edge, 27: metal portion, 29: gradient portion, 29A: reverse gradient portion, 30: solder resist, 30A: inner edge, 30B: outer edge, 32: solder application region, 48: side portion, 50: solder, 52: solder connection portion, 60: electrode, 70: recess, 80: heat dissipation portion, 100: circuit substrate, 200: module.

## Claims

1. A circuit substrate comprising:
a ceramic substrate;
one or more circuit boards bonded to the ceramic substrate; and
solder resist on a surface of at least one of the circuit boards,
wherein, when viewed in a cross section perpendicular to a bonding surface between the circuit board having the solder resist thereon and the ceramic substrate, a distance L₁ between a circuit edge of the circuit board and an inner edge of the solder resist along the bonding surface is 1.0 mm or more.

2. The circuit substrate according to claim 1, wherein, when viewed in the cross section, the circuit board has, at a side portion thereof, a gradient portion expanding toward the bonding surface.

3. The circuit substrate according to claim 1 or 2, wherein, when viewed in the cross section, whole of a side portion of the circuit board is formed to expand toward the bonding surface.

4. The circuit substrate according to claim 1 or 2, when viewed in the cross section, the circuit board has, at a side portion thereof, a gradient portion expanding toward the bonding surface and a reverse gradient portion expanding away from the bonding surface in this order from the bonding surface side.

5. The circuit substrate according to any one of claims 1 to 4, wherein the surface of the circuit board is formed of a plating film containing nickel and phosphorus.

6. The circuit substrate according to any one of claims 1 to 5,
wherein the circuit substrate includes a metal portion and a brazing layer bonding the metal portion and the ceramic substrate,
wherein the brazing layer contains Ag, Cu, Sn, and Ti, and
wherein a content of Sn is more than 4 parts by mass or more of Sn with respect to 100 parts by mass of a total of Ag and Cu.

7. A module comprising:
the circuit substrate according to any one of claims 1 to 6; an electrode electrically connected to the circuit board by solder; and a heat dissipation portion on a side of the circuit substrate opposite to the circuit board side.
